Europäisches Patentamt

European Patent Office

Office européen des brevets

(11) Veröffentlichungsnummer: **0 226 652**
**B1**

(12) **EUROPÄISCHE PATENTSCHRIFT**

(45) Veröffentlichungstag der Patentschrift:
09.05.90

(21) Anmeldenummer: 85116321.2

(22) Anmeldetag: 20.12.85

(51) Int. Cl.⁵: **G01D 5/34**

(54) Sensor.

(43) Veröffentlichungstag der Anmeldung:
01.07.87 Patentblatt 87/27

(45) Bekanntmachung des Hinweises auf die Patenterteilung:
09.05.90 Patentblatt 90/19

(84) Benannte Vertragsstaaten:
AT CH DE FR GB LI

(56) Entgegenhaltungen:
US-A- 3 420 601
US-A- 3 590 374

PATENTS ABSTRACTS OF JAPAN, Band 7,
Nr. 270 (P-240)[1415], 2. Dezember 1983; & JP - A
- 58 150 805

(73) Patentinhaber: Honeywell Regelsysteme GmbH,
Kaiserleistrasse 55, D-6050 Offenbach am Main(DE)

(72) Erfinder: Drefahl, Dieter, Dr., Pferdslache 13,
D-6450 Hanau(DE)

(74) Vertreter: Herzbach, Dieter et al, Honeywell Europe S.A.
Holding KG Patent- und Lizenzabteilung
Kaiserleistrasse 55 Postfach 184, D-6050 Offenbach am
Main(DE)

ACTORUM AG

## Beschreibung

Die vorliegende Erfindung bezieht sich auf einen Sensor nach dem Gattungsbegriff des Patentanspruches 1, der beispielsweise als Annäherungsschalter oder Positionsgeber Anwendung finden kann.

Ein solcher Sensor ist aus der JP-A 58 150 805 bekannt. Dort ist auf einer drehenden Welle ein Permanentmagnet befestigt und gegenüber dieser Welle ist eine magneto-optische Einrichtung angeordnet, die polarisiertes eingestreutes Licht unter Einfluß eines sie durchsetzenden magnetischen Feldes dreht, so daß am Ausgang dieser Einrichtung mehr oder weniger Licht in Abhängigkeit von der Drehstellung der Welle zur Verfügung steht.

Ferner gibt die US-A 3 420 601 bestimmte Materialien an, die einen ausgeprägten magneto-optischen Faraday-Effekt aufweisen, wenn sie in einem Magnetfeld angeordnet werden, wobei dieser Effekt durch Mehrfachreflexionen in dem Material noch gesteigert werden kann.

Ausgehend von dem eingangs genannten Sensor ist es die Aufgabe der vorliegendne Erfindung, diesen so auszubilden, daß er besonders zuverlässig arbeitet und eine hohe Empfindlichkeit aufweist.

Die Lösung dieser Aufgabe gelingt gemäß den kennzeichnenden Merkmalen des Patentanspruches 1. Weitere vorteilhafte Ausgestaltungen des erfindungsgemäßen Sensors sind den abhängigen Ansprüchen entnehmbar.

Anhand von in den Figuren der beiliegenden Zeichnung dargestellten Ausführungsbeispielen sei im folgenden der erfindungsgemäße Sensor näher beschrieben. Es zeigen:

Fig. 1 einen als Annäherungsschalter arbeitenden Sensor gemäß einem ersten Ausführungsbeispiel;

Fig. 2 einen als Annäherungsschalter arbeitenden Sensor gemäß einem zweiten Ausführungsbeispiel;

Fig. 2a eine in Fig. 2 verwendete Reflexions- und Polarisationseinrichtung in näheren Einzelheiten;

Fig. 3 einen wahlweise als Annäherungsschalter oder Positionsgeber arbeitenden Sensor gemäß einem dritten Ausführungsbeispiel; und

Fig. 4 einen als Positionsgeber arbeitenden Sensor.

Ein Joch 10 aus Weicheisen weist einen ersten Luftspalt 12 auf, in welchen ein Permanentmagnet 14 als Betätigungsglied bewegbar ist. Ferner weist dieses Joch einen zweiten Luftspalt 16 auf, in welchem ein optisches Prisma 18 angeordnet ist. Das Prisma 18 besteht vorzugsweise aus Glas und ist in der Lage, zugeführtes Licht zwischen seinen Dachkantflächen total zu reflektieren. In bekannter Weise findet bei der Reflexion des Lichtes auch eine Polarisation des Lichtes statt. Zwei Lichtleiter 20, 24 enden im Abstand voneinander an einer Dachkantfläche des Prismas, wobei über den einen Lichtleiter 20 dem Prisma Licht zugeführt wird und über den anderen Lichtleiter 24 das in dem Prisma 18 mehrfach reflektierte Licht abführbar ist. In den zuführenden Lichtleiter 20 wird beispielsweise über eine lichtemittierende Diode 22 Licht eingespeist, und das an dem Licht abführenden Lichtleiter 24 austretende Licht kann mittels einer Photodiode 26 erfaßt werden.

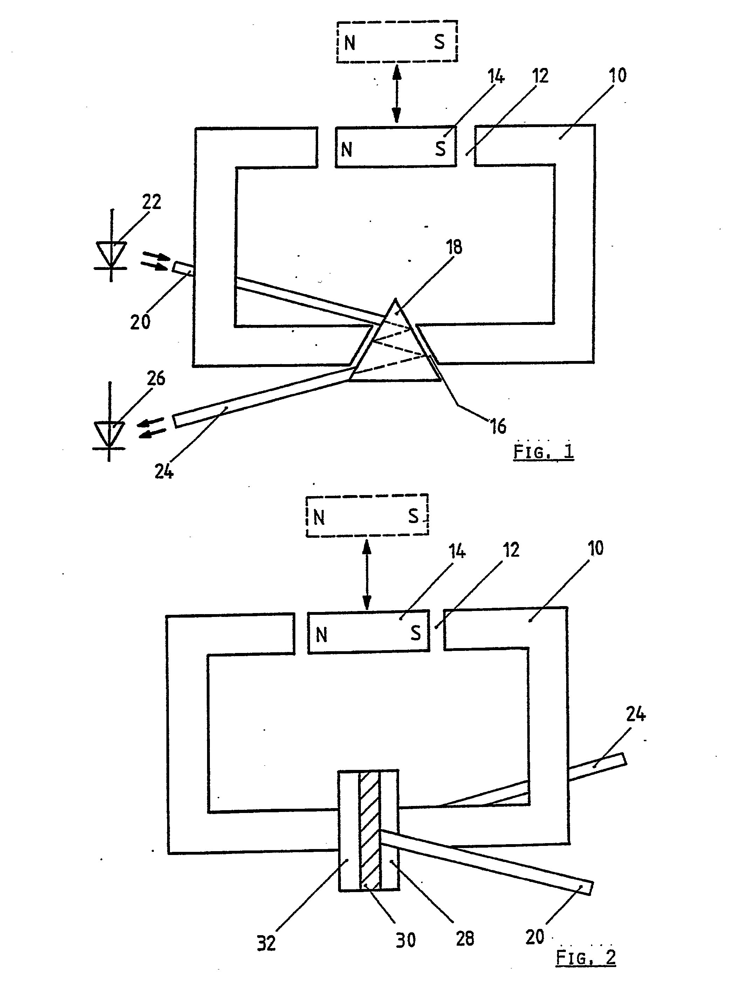

Figur 2 zeigt ein Ausführungsbeispiel, bei dem das als optische Einrichtung für die Polarisation und Mehrfachreflexion verwendete total reflektierende Prisma 18 durch eine Anordnung ersetzt worden ist, die aus einem Polarisationsfilter 30 zwischen zwei auf der Außenseite verspiegelten Glaskörpern 28 und 32 besteht. Gemäß Fig. 2a kann der eine verspiegelte Glaskörper 28 etwas kürzer ausgebildet sein, um unverspiegelte Stellen vorzugeben, an dem die Lichtleiter 20 und 24 und die optische Einrichtung angekoppelt werden können. In den Figuren 2, 2a erstreckt sich die polarisierende und mehrfach reflektierende Einrichtung 28, 30, 32 in der Ebene des weichmagnetischen Joches 10 und das Licht zwischen den beiden Lichtleitern 20 und 24 verläuft ebenfalls in der Ebene des Joches, d.h. in der Zeichenebene.

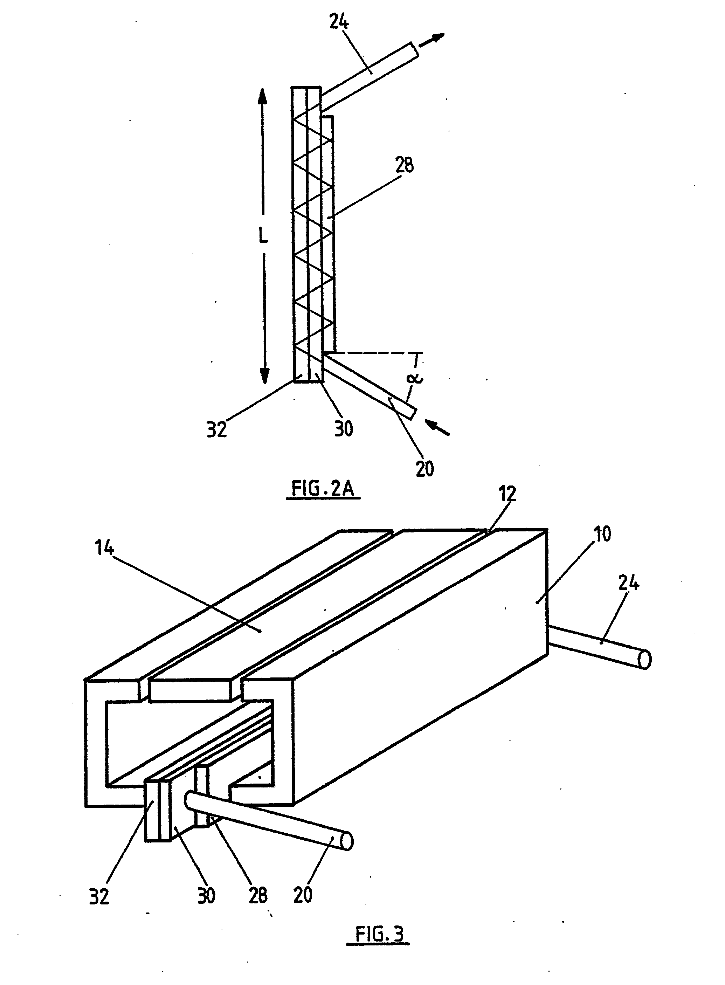

Der Sensor gemäß Figur 3 unterscheidet sich von dem Sensor gemäß Figur 2 dadurch, daß sich die optische Einrichtung 28, 30, 32 senkrecht zur Ebene des Joches 10 und somit senkrecht zur Zeichenebene erstreckt. Entsprechend verläuft das Licht zwischen den beiden Lichtleitern 20 und 24 in der optischen Einrichtung bei seiner Mehrfachreflexion ebenfalls senkrecht zur Ebene des Joches 10.

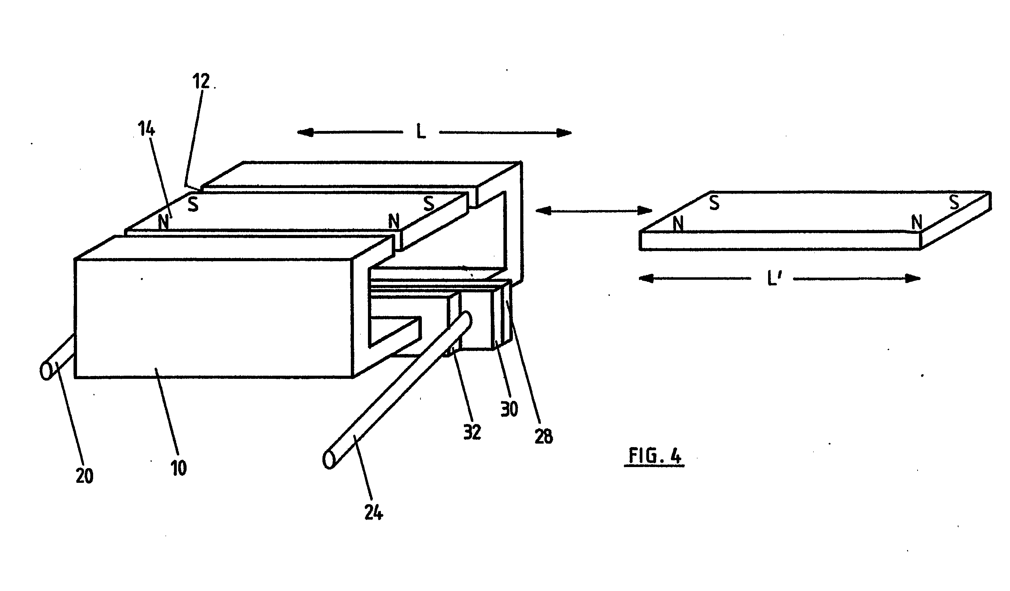

Eine derartige Einrichtung kann nicht nur als Positionsschalter, sondern auch als Positionsgeber verwendet werden, wie dies anhand von Figur 4 veranschaulicht ist. Dort wird der Magnet 14' nicht senkrecht zum Luftspalt 12, sondern in dessen Ebene bewegt. Dann ist die Lichtdurchlaßdämpfung der Anordnung ein Maß für die Position des Magneten. Befindet sich der Magnet 14' über die gesamte Länge 1 in dem Luftspalt 12, so ist die Lichtdämpfung maximal; verschiebt man den Magneten 14' längs des Luftspaltes, so nimmt die Dämpfung ab, bis sie bei vollständigem Verlassen des Luftspaltes ein Minimum erreicht.

Bei allen beschriebenen Ausführungsbeispielen wird von dem magnetooptischen Effekt oder dem sogenannten Faraday-Effekt Gebrauch gemacht. Wenn kein magnetisches Feld an dem Prisma 18 oder der optischen Einrichtung 28, 30, 32 anliegt, so wird das über den Lichtleiter 20 zugeführte Licht n-Mal in dem Prisma bzw. der optischen Einrichtung reflektiert und tritt praktisch unbedämpft über den Lichtleiter 24 wieder aus. Beim Anlegen eines magnetischen Feldes an das Prisma 18 bzw. die optische Einrichtung 28, 30, 32 durch Einbringung eines Magneten 14 bzw. 14' in den Luftspalt 12 wird die Lichtintensität des über den Lichtleiter 24 austretenden Lichtes bedämpft. Durch das längs der Lichtausbreitungsrichtung anliegende Magnetfeld wird die Polarisationsrichtung des polarisierten Lichtes gedreht. Bei jedem der n Durchläufe wird dabei nur der Anteil des Lichtes durchgelassen, dessen Polarisationsebene gleich der des Polarisators ist. Durch die Drehung der Polarisationsebene z.B. um den Winkel $\beta$ wird von dem Polarisationsfilter nur noch ein Bruchteil k ($0 \le k \le 1$) des Lichtes

durchgelassen. Dadurch wird nach n Reflexionen nur noch $k^n$ des eintretenden Lichtes durchgelassen. Bei $k = 0,99$ und $n = 50$ ergibt sich ein Schwächungsfaktor $k^n = 0,605$.

Die Länge 1 der optischen Einrichtung 28, 30, 32, die Dicke d der Glasspiegel 28 und 32 sowie die Feldstärke des Magneten 14 bzw. 14' sind dem Dämpfungsfaktor k des Polarisationsfilters anzupassen. Ebenso sind bei Verwendung eines total reflektierenden Prismas gemäß Fig. 1 die Neigung der Dachkantflächen, das Material des Prismas und der Abstand der beiden Lichtleiter 20 und 24 voneinander an die Gegebenheiten anzupassen und entsprechend zu wählen.

Mittels einer geeigneten Schaltung, die an die Empfangsdiode 26 angeschlossen ist, kann die Licht-Intensitätsänderung am Lichtleiter 24 ausgewertet und als Schalt- bzw. Positionssignal ausgegeben werden.

## Patentansprüche

1. Sensor mit einer durch ein magnetisches Feld beeinflußbaren magneto-optischen Einrichtung (18), und mit an die magneto-optische Einrichtung angekoppelten Lichtleitern (20, 24), um Licht dieser Einrichtung zuzuführen und von dieser abzuführen, dadurch gekennzeichnet, daß die magneto-optische Einrichtung (18; 28, 30, 32) mehrfach reflektierend ausgebildet ist und daß ein weichmagnetisches Joch (10) angeordnet ist, welches einen ersten und einen zweiten Luftspalt (12, 16) aufweist, wobei in den ersten Luftspalt (12) ein Magnet (14, 14') hineinbewegbar ist und in dem zweiten Luftspalt (16) die mehrfach reflektierende magneto-optische Einrichtung (18; 28, 30, 32) angeordnet ist.

2. Sensor nach Anspruch 1, dadurch gekennzeichnet, daß die magneto-optische Einrichtung als total reflektierendes Prisma (18) ausgebildet ist.

3. Sensor nach Anspruch 1, dadurch gekennzeichnet, daß die magneto-optische Einrichtung aus einem Polarisationsfilter (30) zwischen zwei Spiegeln (28, 32) besteht.

4. Sensor nach Anspruch 1, dadurch gekennzeichnet, daß sich die magneto-optische Einrichtung (28, 30, 32) in der Ebene des Joches (10) erstreckt.

5. Sensor nach Anspruch 1, dadurch gekennzeichnet, daß sich die magneto-optische Einrichtung (18, 20, 30, 32) senkrecht zur Ebene des Joches (10) erstreckt.

6. Sensor nach einem der Ansprüche 1 bis 5, dadurch gekennzeichnet, daß der Magnet (14) senkrecht zu dem ersten Luftspalt (12) bewegbar ist.

7. Sensor nach einem der Ansprüche 1 bis 5, dadurch gekennzeichnet, daß der Magnet (14') in der Ebene des ersten Luftspaltes (12) bewegbar ist.

## Claims

1. Sensor comprising a magneto-optical device (18) to be influenced by a magnetic field and photoconductors (20, 24) coupled to the magneto-optical device to direct light to said device and to redirect light from said device, characterized in that the magneto-optical device (18; 28, 30, 32) is a multiple reflecting device and that a soft-iron magnetic yoke (10) is arranged, which comprises a first and a second air gap (12, 16), whereat into the first air gap (12) a magnet (14, 14') is movable and within the second air gap (16) the multiple reflecting device (18; 28, 30, 32) is arranged.

2. Sensor according to claim 1, characterized in that the magneto-optical device is configured as a totally reflecting prism (18).

3. Sensor according to claim 1, characterized in that the magneto-optical device consists of a polarization filter (30) arranged between two mirrors (28), 32).

4. Sensor according to claim 1, characterized in that the magneto-optical device (28, 30, 32) extends in the plane of the yoke (10).

5. Sensor according to claim 1, characterized in that the magneto-optical device (18, 30, 32) extends normal to the plane of the yoke (10).

6. Sensor according to one of claims 1 to 5, characterized in that the magnet (14) is displaced perpendicular to the first air gap (12).

7. Sensor according to one of claims 1 to 5, characterized in that the magnet (14') is displaceable within the plane of the first air gap (12).

## Revendications

1. Capteur comportant un dispositif magnéto-optique (18), pouvant être influencé par un champ magnétique, et des guides de lumière (20, 24) accouplés au dispositif magnéto-optique pour envoyer une lumière à ce dispositif ou retransmettre une lumière à partir de ce dispositif, caractérisé en ce que le dispositif magnéto-optique (18; 28, 30, 32) est agencé de manière à réaliser des réflexions multiples et en ce qu'il est prévu une culasse (10) réalisée en un matériau magnétique doux et possédant des premier et second entrefers (12, 16) un aimant (14, 14') pouvant être introduit dans le premier entrefer (12), tandis que le dispositif magnéto-optique (18; 28; 30, 32), qui produit les réflexions multiples, est disposé dans le second entrefer (16).

2. Capteur selon la revendication 1, caractérisé en ce que le dispositif magnéto-optique est réalisé sous la forme d'un prisme à réflexion totale (18).

3. Capteur suivant la revendication 1, caractérisé par le fait que le dispositif magnéto-optique est constitué par un filtre de polarisation (30) disposé entre deux miroirs (28, 32).

4. Capteur selon la revendication 1, caractérisé en ce que le dispositif magnéto-optique (28, 32) s'étend dans le plan de la culasse (10).

5. Capteur selon la revendication 1, caractérisé en ce que le dispositif magnéto-optique (18, 20, 30, 32) s'étend perpendiculairement au plan de la culasse (10).

6. Capteur selon l'une des revendications 1 à 5, caractérisé en ce que l'aimant (14) est déplaçable perpendiculairement au premier entrefer (12).

7. Capteur selon l'une des revendications 1 à 5, caractérisé en ce que l'aimant (14') est déplaçable dans le plan du premier entrefer (12).

EP 0 226 652 B1

FIG. 1

FIG. 2

FIG.2A

FIG.3

FIG. 4

EP 0 226 652 B1